Europäisches Patentamt

(19) European Patent Office

Office européen des brevets

(11) Publication number: **0 075 681**
**B1**

(12) **EUROPEAN PATENT SPECIFICATION**

(45) Date of publication of patent specification: **18.05.88**

(51) Int. Cl.⁴: **G 06 F 15/336, G 01 R 19/00**

(21) Application number: **82107107.3**

(22) Date of filing: **06.08.82**

(54) Real-time ordinal-value filter utilizing reference-function comparison.

(30) Priority: **28.09.81 US 306256**

(43) Date of publication of application:
**06.04.83 Bulletin 83/14**

(45) Publication of the grant of the patent:
**18.05.88 Bulletin 88/20**

(84) Designated Contracting States:
**DE FR GB**

(56) References cited:
**US-A-2 843 839**
**US-A-3 571 705**
**US-A-3 748 449**
**US-A-3 760 356**
**US-A-3 927 391**

(73) Proprietor: **Hughes Aircraft Company**
**7200 Hughes Terrace P.O. Box 45066**
**Los Angeles California 90045-0066 (US)**

(72) Inventor: **Coleman, Guy B.**
**19124 Clymer Street**
**Northridge California 91326 (US)**
Inventor: **Henderson, James W.**
**22728 Crespi Street**
**Woodland Hills California 91364 (US)**
Inventor: **Sacks, Jacob M.**
**815 Tamlei Street**
**Thousand Oaks California 91360 (US)**

(74) Representative: **Kuhnen, Wacker & Partner**
**Schneggstrasse 3-5 Postfach 1729**
**D-8050 Freising (DE)**

Courier Press, Leamington Spa, England.

## Description

### Cross-reference to related applications

Here incorporated by reference is the disclosure of the following related, copending, common-assignee patent application: "Real-Time Ordinal-Value Filter Utilizing Half-Interval Ranking." (EP—A—0 075 684)

### Background of the invention

#### 1. Field of the invention

The invention relates in general to signal processing apparatus and in particular to networks for determining the Mth-largest value of an input data set. The invention has special relevance in those environments, such as image processing, where it is advantageous to perform this value determination in real time.

#### 2. Description of the prior art

Presented here is the concept of an ordinal-value filter which determines which one of a set of R applied data values is the Mth-largest. When $R$ is odd and M is made equal to $((R+1)/2)$, the Mth-largest becomes the "middle' value of the data set, having in general an equal number of other data values both larger than and smaller than itself. Such a middle value is designated the median. A median filter is one which determines or selects this median value from an input data set.

Although both the basic concept of the median filter and its use in the field of image processing are well-known, many prior realizations have depended upon time-consuming software routines.

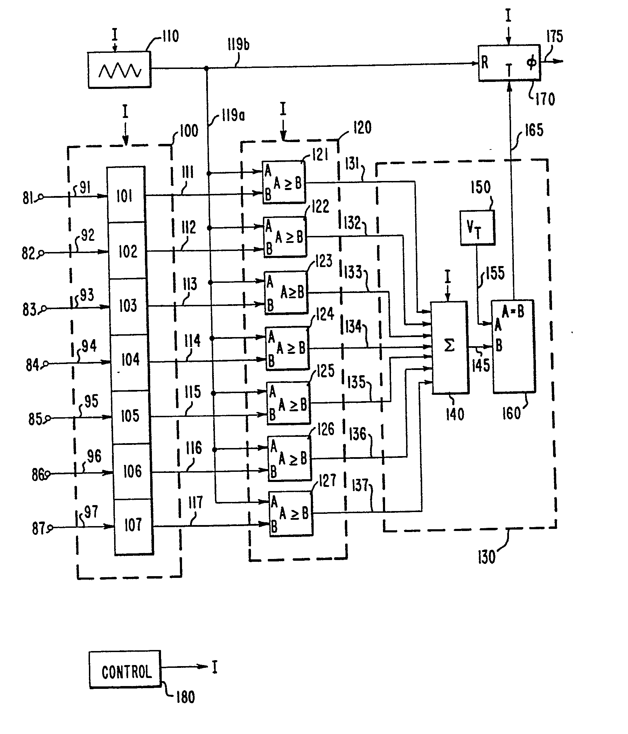

Prior-art network concepts capable of being mechanized as hardward-economical, ordinal-value filter which perform the required determinations at the incoming data rate are presented by D.E. Knuth in Volume 3 of his book *"The Art of Computer Programming: Sorting and Searching"* (1973). See especially the odd-even transposition sorting networks given in Knuth's Figure 58 on page 241.

It should be noted, however, that the inventions claimed in this specification are considered to be patentably different from Knuth's concepts, as well as from the network concepts and mechanizations presented in the incorporated application.

A real-time ordinal-value-filtering capability is extremely useful, especially, for example, in those situations where the ordinal-value processing of dynamic images is of greatest value when it can be performed as the images are occurring.

### Summary of the invention

It is an aim of this invention, therefore, to provide apparatus for determining the Mth-largest value of a set of input data values.

It is also an aim of this invention to provide apparatus for performing such determinations with a minimum amount of hardware.

It is another aim of this invention to provide minimum-hardware implementations which can perform such determinations efficently in real time.

These and other aims are achieved by the disclosed invention which in one of its aspects provides a hardware mechanization for determining, at real-time data rates, which one of a set of R input data signals is the Mth-largest. The determination is based upon a comparison between the input data and a monotonically-scanning reference function. At that point when the lower $(R-M+1)$ of the input data signals have been equaled by an increasing scanning reference, the reference has become the same as the Mth-largest and is used as the filter output. Analagous operation is achieved with a decreasing reference. In another of the invention's aspects, the network becomes a real-time median filter when the number R of inputs is odd and M is made equal to $((R+1)/2)$.

### Brief description of the drawings

These and other objects and advantages will become apparent from a study of the following specification when considered in conjunction with the accompanying drawing in which:

The Figure shows a hardware network as an example implementation of the reference-comparison concept in which the monotonically-varying values of a scanning reference function are compared with all of the input data signals.

### Detailed description of the invention

#### I. The Reference-Comparison Network

#### A. Overview

Included within the general scope of the invention is the illustrative embodiment depicted in the Figure in which a set of input data signals from register 100 is compared by reference comparators 120 with a reference function from generator 110. This function monotonically scans over the entire range of values possible for the input data. Summation subnetwork 140 totals the number of comparators which have indicated equality between the reference function and the individual data values. When the reference function sweeps from the interval's lower end to its higher end, and when the comparator output voltages are of equal magnitude, the summation total provides an indiction of when the reference function has become equal to the desired Mth-largest input value. For R applied data values, this upward-scan threshold summation level will be $(R-M+1)$ times the comparator output-signal magnitude. When threshold comparator 160 indicates that this threshold has been reached, sample-and-hold subnetwork 170 causes the reference function's threshold-trigger value to exit from the apparatus as the network's selection for the desired Mth-largest value.

#### B. Implementation Details

#### 1. Input Storage Register

Input storage register 100 receives and stores a set of R subject data signals. The illustrative embodiment has provisions for processing an R-unit set of up to R=7 signals with the individual elements of the signal set being held in subregisters 101 through 107. By biasing off an appropriate number of these subregisters, signal sets of different sizes can also be accommodated without impairing the effectiveness of the present embodiment's ordinal-value-determination operation.

In the example mechanization, the data signals are received at connections 81 through 87 from external sources not shown. As one of many alternatives still encompassed within the inventive concept, subregisters 101 through 107 could themselves be direct-sensing storage elements such as charge-coupled devices, thus eliminating the need for external source connections. Nevertheless, when in fact derived from external sources in accordance with the depicted example embodiment, the signals are carried over channels 91 through 97 into the respective subregisters. As implemented, the signals are analog values, and the subregisters are analog storage devices. (The processing of digital data stored in digital input registers will be discussed below.)

In another alternative still encompassed within the inventive concept, input register 100 could be an analog shift register having successive subregisters 101 through 107. Such a register could receive over channel 91 from connection 81 the individual elements of a serially-presented data stream. By means of either conventional timing and control techniques or an initialization signal to be described below, these individual data signals would be made to shift through the successive subregisters as subsequent data-stream elements were received.

In this shift-register configuration, the subject data sets whose Mth-largest value is to be formulated would be the successive R-unit clusters of data-stream elements as contained in the input register at any given time.

2. Reference Generator

Reference generator 110 produces on channel 119 a reference signal whose values scan over the entire range "T" of values which the input data might assume. In many instances it is convenient to arrange for the value scan to be monotonic over the interval of interest. For each given set of data values, the reference function is scanned from one end of the value interval to the other. For example, when the data can cover the positive values from zero to an upper limit T, a monotonically-*increasing* reference function would be scanned from zero through T. When the data can occur within the range of −(T/2) through +(T/2), the reference function would be scanned from −(T/2) through +(T/2). It is apparent that in a functionally-equivalent mechanization, ther reference function could be made monotonically-*decreasing*, by scanning from the higher end of the value interval to the lower end.

In order to operate iteratively with a succession of input data sets, reference generator 110 could be configured to produce a *periodic* waveform which scans montonically during each period. The period of the waveform would be chosen so that at least one monotonic value-scan occures during the time when a subject data set is held in register 100. In an example mechanization, the periodic waveform chosen could be that of an analog sawtooth signal, continuous over the value interval of interest.

3. Reference comparators

Each of the reference comparators 121 through 127 receives as one of its inputs the reference waveform from channel 119a. As its other input, each receives over channels 111 through 117 a unique one of the data values from the input strage register. Each comparator then compares the associated data value to the scanning reference signal.

As implemented, these comparators are analog devices whose output channels 131 through 137 remain inactive until the instant of substantial equality between the analog reference waveform and the given analog input data value. At that instant of equality, each comparator produces an affirmative comparison-output signal, such as a logic zero-to-logic one transition, which is sent to summation subnetwork 140.

In a functionally-equivalent digital mechanization, the comparators would be digital devices comparing digital data values from a digital input storage register with a digital reference signal produced by a digital reference generator such as a high-speed counter. If a digital application were to arise in which it was possible to tolerate more of a discrepancy between the outputted reference value and the true Mth-largest data value, the speed of the digital scanning reference function could be increased by setting the generator to produce greater than-unity count increments for its value scan. In such an increased-speed situation, each comparator could be adjusted to activate its output line when an *increasing* reference function was either equal to or *greater* than the respective data value. The corresponding adjustment for the case of a *decreasing* reference would be an "equal to or *less* than" condition.

4. Thresholding Network

The filter includes a thresholding network 130 which receives the comparison-output signals and in effect analyses them so as to determine whether they indicate that predeterminable threshold conditions have been satisfied. If so, the network generates an appropriate threshold-output indication. In the example illustrated embodiment, thresholding network 130 includes summation subnetwork 140, selectable-threshold generator 150 and threshold comparator 160.

a. Summation Subnetwork

In one of its fundamental aspects, the present filter is directed toward selecting at its output that reference-function value which matches or approximates to within a desired degree of accuracy the Mth-largest value of a set of R input data signals. For a monotonically-*increasing* reference function, the reference will have reached the value of interest at that point in time when the lower $(R-M+1)$ of the data values have been substantially equaled, in the sense of having been either actually equaled or instead surpassed by the scanning reference. For a monotonically-*descreasing* reference function, the reference will have reached the value of interest at that point in time when the upper M of the data values have been analogously equaled or passed by the scanning reference.

By accumulating the comparison-output signals presented on channels 131 through 137, conventional summation subnetwork 140 generates an output sum pattern which gives a direct indication of the number of input data values which have been equaled or surpassed by the monotonically-scanning values of the implemented increasing reference function. The reference-value-selection objective can thus be achieved in a readily-predeterminable fashion by monitoring and properly interpreting this output-sum pattern.

In the analog realization depicted in the Figure, the magnitudes of the individual comparison-output signals are made equal. When accumulated by an analog summation subnetwork, these signals cause an equal-step staircase waveform to be produced on output channel 145. The resulting equal-magnitude steps of the analog staircase provide the direct indication of the number of comparators whose respective analog data values have been at least equaled by an upwardly-scanning analog reference function.

. In a substantially equivalent digital mechanization, summation subnetwork 140 could be a read only memory (ROM) which would output onto a digital-data-bus version of output channel 145 a digital indication of the number of reference comparators whose outputs had been activated by conditions of equality or excession between a digital reference function and digital data values. An ROM could readily be made to achieve such operation by configuring it to receive, as memory addresses, appropriate digital-logic versions of the comparison-output signals. These comparison-output addresses would then access memory locations whose contents would be the appropriate number indications. (It is, of course, possible to use a digital summation subnetwork when the reference and data values are themselves analog, or to conversely use an analog summation subnetwork when the reference and data values are themselves digital.)

The output of the summation subnetwork will indicate that the reference has reached the value of interest when, if analog, the staircae waveform reaches the $(R-M+1)$st step or when, if digital, the binary output reaches the value $(R-M+1)$, with either output form providing an Mth-largest ranking ranking-condition indication that $(R-M+1)$ comparators have been activated. For a monotonically-decreasing reference function, the appropriate ranking quantities would respectively be the Mth step or the number M itself.

b. Selectable-Threshold Generator

Selectable-threshold generator 150 produces a rank-count signal indicative of the example ranking quantity $(R-M+1)$. In the case of an analog mechanization, this rank-count signal would be the voltage level equal to $(R-M+1)$ times the magnitude of any one of the equal magnitude comparison-output signals from comparators 121 through 127. This voltage level would be carried over channel 155 to comparator 160. In a digital mechanization, the rank-count signal would be the binary representation of the number $(R-M+1)$. In this situation, channel 155 would become a digital data bus having a sufficient number of lines to carry the individual bits of the resulting binary number.

c. Theshold Comparator

Threshold comparator 160 compares the summation-output signal received over channel 145 at input B with the threshold level received over channel 155 at input A. When the two have become equal, with this equality thus indicating that the requisite Mth-ranking condition number of comparators have become activated, the device activates its threshold-output channel 165 which then acts as a trigger signal for sample-and-hold subnetwork 170.

d. Threshold Substitution

In another fundamentally-equiivalent mechanization of threshold network 130, the above-noted ROM could be configured not only to perform the functions of a summation subnetwork but also to obviate the necessity for both the threshold generator and threshold comparator. This "one-for-three" substitution could be achieved by specially coding the ROM. In accordance with this special coding, and once again utilizing digital-logic versions of the comparison-output signals as memory addresses, the device could be configured so that predetermined ones of its memory locations contained the representation for a first threshold-output signal, while the remainder of its memory locations contained the representation for a second threshold-output signal. (In an actual implementation these first and second signals could respectively be logic "one" and logic "zero.") The memory locations chosen for the first signal would be those whose ensemble comparison-output addresses correspond to a comparison-output pattern which would have satisfied the above-described digital threshold conditions. The complementary locations chosen for the second signal would be those for which the associated comparison-output pattern would *not* satisfy the described threshold conditions.

5. Sample-And-Hold Subnetwork

Over subchannel 119b, subnetwork 170 receives at input "R" all values of the monotonically-scanning reference function. At input "T" is received the trigger signal produced by comparator 160 when the output of the summation subnetwork has become equal to the threshold ranking quantity. When triggered, network 170 passes onto output channel 175 that reference value which caused the requisite number of reference comparators to become activated. In a situation of relatively-slow data rates with a resulting relatively-long scanning period for the reference function, the reference value so sampled is an acceptable approximation to the desired Mth-largest data value.

The resulting ordinal-output value is analog in the implemented network and would be a digital number in a digital mechanization.

## 6. Reinitialization

Once the appropriate reference value has been transmitted over channel 175, the example network can be prepared for the processing of a new set of data by an initialization signal "I" received from a conventional control unit 180. In addition to the register-1000 serial initilization described above, this signal causes the existing value to be cleared from sample-and-hold subnetwork 170, causes summation subnetwork 140 to be set to zero, and can be utilized both to reset comparators 120 as well as to initiate or synchronize reference generator 110. For the case of data presented in parallel over channels 91 through 97, initialization could be used to cause *all* existing data values in register 100 to be cleared, thereby preparing the register for the receipt of a new data-signal set.

## II. Equal-Data Ambiguities

The presence of equal data values among the members of a given R-unit data set is considered to give rise to an ambiguity in that the equality creates a discrepancy between the number of *magnitudes* and the number of *signals* which the data set contains.

From the standpoint of terminology, such ambiguities are resolved by means of a special definition. In accordance with this definition, expressions such as "Mth-largest" (in the sense of the Mth-largest *magnitude*) are specially defined as being a designation for that data-set element which would occupy the Mth *position* in an ordered-by-magnitude listing of the set's data signals. Furthermore, it may be observed that, from the standpoint of device operation, such ambiguities present no significant difficulties for the invention of the present specification.

## III. Operational Advantages

When the number R of inputs is odd and M is made equal to the quantity $((R+1)/2)$, the described network becomes a median filter which outputs a data value that in general has an equal number of other subject input data values both greater than and less than itself. A special advantage of such a mediam filter implemented as described in the figure-depicted example mechanization given above is its ability to generate the median value at real-time data rates.

## Claims

1. Apparatus for generating a signal which closely approximates the Mth-largest of the possible ranking number of a set of R applied data signals at real time, where the possible values of said applied signals can extend over a total interval T, this apparatus characterised by:

A) input storage means (100), for receiving and accessibly storing the subject set of R data signals (91—97);

B) reference-generator means (110), for providing a reference signal (119a, b) whose values scan over said total interval T, with at least one such scan occuring for each data set applied;

C) comparison means (120), responsive to said reference signal (119a) and to said applied data signals (91—97).

a) for comparing each of the applied data signals (91—97) to said reference signal (119a), and

b) for producing a plurality of R distinct comparison-output signals (131—137), each indicative of the occurrence of a condition of substantial equivalence between said reference signal (119a) and a given one of the data signals (91—97);

D) thresholding means (130), responsive to said comparison-output signals (131—137),

a) for determining whether said comparison-output signals (131—137) indicate that a predetermined ranking-condition number of said data signals (91—97) have been substantially equaled by said scanning reference signal (119);

b) for generating a threshod-output signal (165) indicative of the occurrence of said predetermined number of equality indcations; and

E) sampling means (170), responsive to said reference signal (119b) and to said threshold-output signal (165), for sampling and outputting as an ordinal-output signal (175) that signal value which said reference-generator means (110) produces at the time of the generation of said threshold-output signal. (165), whereby said ordinal-output signal (175) closely approximates that particular input data signal (91—97) which is the Mth-largest of the R applied signals.

2. An apparatus according to Claim 1 in which:

A) said comparison means (120) includes:

a plurality of R reference-comparison means (121—127), all of said reference-comparison means receiving said reference signal (119a), and each thereof (121—127) receiving a single and mutually-different one (111—117) of said data signals (91—97),

each of said reference comparion means (121—127) being for generating a unique one of said distinct comparison-output signals (131—137), this signal being generated when ever the value of said reference signal (119a) has become equal to or has scanned past the value of said one data signal, where all of said output signals (131—137) are of equal mangnitude; and

B) said thresholding means (130) includes:

a) summation means (140), having a sum value initialized at zero before the value scan of said reference signal (119a), and responsive to all of said comparison-output signals (121—127), said summation means (140) being for forming and storing, each time a comparison output is generated, a new sum value (145) by adding each generated one of said comparison signals (121—127) to the last-formed sum;

b) selectable-threshold-generator means (150), for producing a rank-count threshold signal (155) indicative of said ranking-condition quantity;

c) threshold-comparison means (160), responsive to said sum value (145) and to said rank-count threshold signal (155), said thresholding means being for generating a trigger signal (165) when said sum value reaches said rank-count threshold, said trigger signal (165) serving as said threshold-output indication.

3. Apparatus according to Claim 1 or 2 wherein:

A) the reference signal (119a) monotonically scans over said total interval T and said values of said reference signal (119a) scan from the lower end of said interval T to the interval's higher end; and

B) said ranking-condition quantity is given by (R−M+1).

4. Apparatus according to Claim 1 or 2 wherein:

A) the reference signal (119a) monotonically scans over said total interval T and said values of said reference signal (119a) scan from the higher end of said interval T to the interval's lower end; and

B) said ranking-condition quantity is given by quantity M.

5. Apparatus according to any preceding claims in which:

A) said apparatus further includes:

control generator means (180), this means being

a) connected to said sampling means (170) and to said summation means (140) for initializing both of said means by clearing their existing values; and

b) connected also to said input storage means (100), for initializing said means so as to accomodate a new set of R applied data signal (91—97); and in which

B) said reference generator means (110) is adapted to provide said reference (119a, b) signal periodically, the start of the period coinciding with the receipt of said applied data signals (91—97);

whereby said apparatus becomes adapted to produce a succession of ordinal-output signals (175) in response to a successive application of a sequence of data-signal sets.

**Patentansprüche**

1. Vorrichtung zum Erzeugen eines Signals, welches die M-größte der Rang-Ordnungszahl einer Gruppe von R in Echtzeit angelegten Datensignalen eng annähert) wobei die möglichen Werte der angelegten Signale sich über ein Gesamtintervall T erstrecken können, gekennzeichnet durch:

A) eine Eingangsspeichervorrichtung (100) zum Empfangen und zugänglichem Speichern der gegenständlichen Gruppe von R-Datensignalen (91—97);

B) eine Referenzgeneratorvorrichtung (110), zum Bereitstellen eines Referenzsignals (119a, b), dessen Wert das Gesamtintervall T überstreicht, wobei wenigstens eine solche überstreichung für jede angelegte Datengruppe auftritt;

C) eine Vergleichsvorrichtung (120), welche auf das Referenzsignal (119a) und auf die angelegten Datensignale (91—97) anspricht,

a) zum Vergleichen jedes der angelegten Datensignale (91—97) mit dem Referenzsignal (119a), und

b) zum Erzeugen einer Mehrzahl von R abgesonderten Vergleichs-Ausgangssignalen (131, bis 137) von denen jedes das Auftreten eines Zustandes einer wesentlichen übereinstimmung zwischen dem Referenzsignal (119a) und eines gegebenen der Datensignale (91—97) anzeigt;

D) eine Schwellenvorrichtung (130), welche auf die Vergleichs-Ausgangssignale (131—137) anspricht,

a) zum Bestimmen, ob die Vergleichs-Ausgangssignale (131—137) anzeigen, daß eine festgelegte Rang-Zustandszahl der Datensignale (91—97) durch das Abtast-Referenzsignal im wesentlichen übeinstimmend gemacht wurde;

b) zum Erzeugen eines Schwellen-Ausgangssignals (165), welches das Auftreten der festgelegten Anzahl von übereinstimmungs-Anzeigen anzeigt; und

E) eine Abtastvorrichtung (170), welche auf das Referenzsignal (119b) und auf das Schwellen-Ausgangssignal (165) anspricht, zum Abtasten und Ausgeben als ein Ordnungs-Ausgangssignal (175), des Signalwertes, den die Referenz-Generatorvorrichtung (110) während der Zeit des Erzeugens des Schwellen-Ausgangssignals (165) erzeugt, wobei das Ordnungs-Ausgangssignal (175) das spezielle Eingangsdatensignal (91—97), das das M-größte von den R angelegten Signalen ist, eng annähert.

2. Vorrichtung nach Anspruch 1, in der:

A) die Vergleichsvorrichtung (120) aufweist:

eine Mehrzahl von R Referenz-Vergleichsvorrichtungen (121—127), wobei alle die Referenz-Vergleichsvorrichtungen das Referenzsignal (119a) empfangen und jede davon (121—127) ein einzelnes und wechselseitig unterschiedliches (111—117) der Datensignale (91—97) empfängt, wobei jede der Referenz-Vergleichsvorrichtungen (121—127) zum Erzeugen eines eindeutigen der ausgesonderten Vergleichs-Ausgangssignale (131—137) dient, wobei dieses Signal immer dann erzeugt wird, wenn der Wert des Referenzsignals (119a) gleich geworden ist zu oder abgetastet worden ist über den Wert des einen Datensignals, wobei alle die Ausgangssignale (131—137) von gleicher Größe sind; und

B) die Schwellenvorrichtung (130) aufweist:

a) eine Summationsvorrichtung (140), welche einen Summenwert hat, der vor dem Abtastwert des Referenzsignals (119a) bei O durch das Abtast-Referenzsignal (119) initialisiert wird und auf alle die Vergleichs-Ausgangssignale (121—127) anspricht, wobei die Summationsvorrichtung (140) zum Bilden und Speichern eines neuen Summenwertes (145) vorhanden ist, durch Addieren jedes erzeugten von den Vergleichssignalen (121—127) zu der zuletzt gebildeten Summe, jedesmal wenn ein Vergleichsausgang erzeugt wird;

b) eine selektierbare Schwellen-Generatorvorrichtung (150), zum Erzeugen eines Rang-Zähl-Schwellensignals (155), welches auf die Rang-Zustandsmenge hinweist;

c) eine Schwellen-Vergleichsvorrichtung (160), welche auf die Summenwerte (145) und auf das Rang-Zähl-Schwellensignal (155) anspricht, wobei die Schwellenvorrichtung zum Erzeugen eines Triggersignals (165) vorgesehen ist, wenn der Summenwert die Rang-Zähl-Schwelle erreicht, wobei das Triggersignal (165) als die Schwellen-Ausgangsanzeige dient.

3. Vorrichtung nach Anspruch 1 oder 2, worin:

A) das Referenzsignal (119a) das Gesamtintervall T monoton überstreicht und die Werte der Referenzsignale (119a) vom niedrigen Ende des Intervalls T zum höheren Ende des Intervalls reichen; und

B) die Rang-Zustandsmenge durch (R−M+1) gegeben ist.

4. Vorrichtung nach Anspruch 1 oder 2, worin:

A) das Referenzsignal (119a) das Gesamtintervall T monoton überstreicht und die Werte des Referenzsignals (119a) vom höheren Ende des Intervalls T zum niedrigen Ende des Intervalls reichen; und

B) die Rang-Zustandsmenge durch die Menge M gegeben ist.

5. Vorrichtung nach einem der vorhergehenden Ansprüche in der:

A) die Vorrichtung weiterhin aufweist:

eine Steuergeneratorvorrichtung (180), wobei diese Vorrichtung

a) mit der Abtastvorrichtung (170) und mit der Summationsvorrichtung (140) verbunden ist, zum Initialisieren der beiden Vorrichtungen durch Löschen der bestehenden Werte; und

b) auch mit der Eingangsspeichervorrichtung (100) verbunden ist, zur Initialisierung der Vorrichtung, um so eine neue Gruppe von R angelegten Datensignalen (91—97) aufzunehmen; und in welcher

B) die Referenzgeneratorvorrichtung (110) zum periodischen Bereitstellen des Referenzsignals (119a, b) angepaßt ist, wobei der Beginn der Periode mit dem Empfang der angelegten Datensignale (91—97) übereinstimmt; und

wobei die Vorrichtung zum Erzeugen von aufeinanderfolgenden Ordnungs-Ausgangssignalen (175) als Antwort auf ein aufeinanderfolgendes Anlegen einer Sequenz von Datensignalgruppen angepaßt wird.

**Revendications**

1. Appareil destiné à générer un signal représentant une excellente approximation du signal dont le rang correspond au M-ième plus grand des signaux d'un ensemble de R signaux de données appliqués en temps réel, dans lequel les valeurs possibles des signaux appliqués peuvent s'étendre sur un intervalle total T, cet appareil étant caractérisé par:

A) des moyens d'enregistrement d'entrée (100), destinés à recevoir et à enregistrer de manière accessible l'ensemble considéré de R signaux de données (91—97);

B) des moyens générateurs de référence (110), destinés à fournir un signal de référence (119a, b) dont les valeurs balaient l'intervalle total T, au moins un balayage de ce type ayant lieu pour chaque ensemble de données appliqué;

C) des moyens de comparaison (120), qui réagissent au signal de référence (119a) et aux signaux de données appliqués (91—97),

a) en comparant chacun des signaux de données appliqués (91—97) avec le signal de référence (119a), et

b) en produisant un ensemble de R signaux de sortie de comparaison distincts (131—137), chacun d'eux indiquant l'apparition d'une condition d'équivalence pratique entre le signal de référence (119a) et l'un déterminé des signaux de données (91—97);

D) des moyens de définition de seuil (130), qui réagissent aux signaux de sortie de comparaison (131—137),

a) en déterminant si les signaux de sortie de comparaison (131—137) indiquent que le signal de référence effectuant un balayage (119) a pratiquement égalé un nombre prédéterminé de conditions de rang des signaux de données (91—97);

b) en générant un signal de sortie de seuil (165) qui indique l'apparition du nombre prédéterminé d'indications d'égalité; et

E) des moyens d'échantillonnage (170), qui réagissent au signal de référence (119b) et au signal de sortie de seuil (165), en échantillonnant et en émettant sous la forme d'un signal de sortie de valeur ordinale (175) la valeur de signal que les moyens générateurs de référence (110) produisent à l'instant de la génération du signal de sortie de seuil (165), grâce à quoi le signal de sortie de valeur ordinale (175) représente une excellente approximation du signal de données d'entrée particulier (91—97) qui est le M-ième plus grand des R signaux appliqués.

2. Un appareil selon la revendication 1 dans lequel:

A) les moyens de comparaison (120) comprennent:

un ensemble de R moyens de comparaison de référence (121—127) tous ces moyens de comparaison de référence recevant le signal de référence (119a), et chacun d'eux (121—127) recevant un seul signal mutuellement différent (111—117) parmi les signaux de données (91—97), chacun des moyens de comparaison de référence (121—127) étant destiné à générer l'un particulier des signaux de sortie de comparaison distincts

(131—137), ce signal étant généré chaque fois que la valeur du signal de référence (119a) est devenue égale au signal de données considéré, ou est passée au-delà de cette valeur, tous les signaux de sortie (131—137) ayant une amplitude égale; et

B) les moyens de définition de seuil (130) comprennent:

a) des moyens de sommation (140) ayant une valeur de somme qui est initialisée à zéro avant le balayage de valeur du signal de référence (119a), et qui réagissent à tous les signaux de sortie de comparaison (121—127), ces moyens de sommation (140) ayant pour fonction de former et d'enregistrer une nouvelle valeur de somme (145), chaque fois qu'un signal de sortie de comparaison est généré, en additionnant à la somme formée en dernier chaque signal généré parmi les signaux de comparaison (121—127);

b) des moyens générateurs de seuil avec possibilité de sélection (150), destinés à produire un signal de seuil de valeur de comptage de rang (155) représentatif de la quantité définissant la condition de rang;

c) des moyens de comparaison de seuil (160), fonctionnant sous la dépendance de la valeur de somme (145) et du signal de seuil de valeur de comptage de rang (155), les moyens de définition de seuil ayant pour fonction de générer un signal de déclenchement (165) lorsque la valeur de somme atteint le seuil de valeur de comptage de rang, et ce signal de déclenchement (165) constituant l'indication de sortie de seuil.

3. Appareil selon la revendication 1 ou 2, dans lequel:

A) le signal de référence (119a) balaie de façon monotone l'intervalle total T, et les valeurs du signal de référence (119a) effectuent un balayage depuis l'extrémité inférieure de l'intervalle T jusqu'à l'extrémité supérieure de l'intervalle; et

B) la quantité définissant la condition de rang est donnée par (R−M+1).

4. Appareil selon la revendication 1 ou 2 dans lequel:

A) le signal de référence (119a) balaie de façon monotone l'intervalle total T, et les valeurs du signal de référence (119a) effectuent un balayage depuis l'extrémité supérieure de l'intervalle T jusqu'à l'extrémité inférieure de l'intervalle; et

B) la quantité définissant la condition de rang est donnée par la quantité M.

5. Appareil selon l'une quelconque des revendications précédentes, dans lequel:

A) cet appareil comprend en outre;

des moyens générateurs de commande (180) ces moyens étant

a) connectés aux moyens d'échantillonage (170) et aux moyens de sommation (140), pour les initialiser tous les deux en effaçant leurs valeurs existantes; et

b) connectés également aux moyens d'enregistrement d'entrée (100), pour initialiser ces moyens de façon à accepter un nouvel ensemble de R signaux de données appliqués (91—97); et dans lequel

B) les moyens générateurs de référence (110) sont conçus de façon à fournir le signal de référence (119a, b) de façon périodique, le début de la période coïncidant avec la réception des signaux de données appliqués (91—97); grâce à quoi cet appareil est ainsi capable de produire une succession de signaux de sortie de valeur ordinale (175) sous l'effet de l'application successive d'une séquence d'ensembles de signaux de données.